# EUROPEAN PATENT SPECIFICATION

(11) **EP 0 949 669 B1**
(45) Date of publication and mention of the grant of the patent: **28.03.2007**
(21) Application number: 99106823.0
(22) Date of filing: 06.04.1999
(51) Int. Cl.: H01L 21/60, H01L 21/285, H01L 21/28

(54) **Method of fabricating semiconductor device**
Herstellungsverfahren einer Halbleiteranordnung
Méthode de fabrication d'un dispositif semiconducteur

(30) Priority: 07.04.1998 JP 11148098
(43) Date of publication of application: 13.10.1999
(73) Proprietor: SEIKO EPSON CORPORATION, Shinjuku-ku Tokyo 163-0811 (JP)
(72) Inventor: Kawahara, Kei, Suwa-shi, Nagano-ken (JP)
(74) Representative: Hoffmann, Eckart

(56) References cited:
- EP-A- 0 607 820
- US-A- 4 512 073
- US-A- 4 888 297
- US-A- 5 144 390
- PATENT ABSTRACTS OF JAPAN vol. 017, no. 568 (E-1447), 14 October 1993 (1993-10-14) -& JP 05 166798 A (SONY CORP), 2 July 1993 (1993-07-02)

## Description

### BACKGROUND OF THE INVENTION

### Field of the Invention

This invention relates to a method of fabricating a semiconductor device, and, in particular, to a method of fabricating a semiconductor device having a configuration such that an impurity region and a wiring film are connected electrically.

### Description of Related Art

Electrical contact between the source/drain of a field effect transistor and a wiring film thereabove is generally done by using a contact hole. In other words, an interlayer dielectric film is first formed on the source/drain, the interlayer dielectric film is selectively etched away to form a contact hole through which the source/drain is exposed, and then a wiring film is formed on the interlayer dielectric film and within the contact hole. Demands for further miniaturization of semiconductor devices has lead to decreases in the dimensions of the source and drain. It can therefore happen that the contact hole is not located completely above the source/drain. In other words, the contact hole may be located above the boundary between an edge portion of the field oxide film and the source/drain. In such a case, the etching used for forming the contact hole will etch away this edge portion of the field oxide film, exposing the main surface of the silicon substrate. If the thus exposed main surface is placed in electrical contact with the wiring film, a problem will arise in that current from the wiring film will leak into the silicon substrate.

Therefore, after the contact hole is formed, ions are implanted into the main surface of the silicon substrate through the contact hole, to form an impurity region of the same conductivity type which overlaps at least part of the source/drain. This technique is disclosed in Japanese Patent Application Laid-Open No. 6-204173, by way of example.

A method according to the pre-characterizing portion of claim 1 is known from EP 0 607 820 A. In this prior art the annealing to activate implanted ions is said to be preferably performed at a high temperature and a short time by means of e.g. a halogen lamp.

The document US 5,144,390 A discloses a method of fabricating a semiconductor device and reports that it has been found that in the formation of a boron-doped p⁺ region in an n-channel LDD transistor the implant profile of boron can result in counterdoping of the source-side LDD region. This counterdoping is said to be due primarily to the large lateral straggle of implanted borons from the defining mask edge. To prevent such counterdoping the document teaches to perform the drive-in anneal for the n-type source/drain implants prior to the implant of the p-type dopant for the p⁺ region. This anneal is a conventional anneal, for example an anneal in an inert ambient at a temperature in the range from 850 to 900 °C, for a time in the range from 40 to 60 minutes:

### SUMMARY OF THE INVENTION

An objective of this invention is to provide a method of fabricating a semiconductor device that makes it possible to reliably reduce the magnitude of current leaking into the semiconductor substrate.

This object is achieved by a method as claimed in claim 1. Preferred embodiments of the invention are subject-matter of the dependent claims.

The inventor of this invention has verified by experimentation that annealing the second impurity region at 780°C to 900°C will reduce the magnitude of current leaking into the semiconductor substrate compared with the annealing outside that range. Therefore, this invention makes it possible to reliably reduce the magnitude of current leaking into the semiconductor substrate, thus making it possible to improve the performance of the resultant semiconductor device.

The method of fabricating a semiconductor device in accordance with this invention may further comprise: a step of forming an element separation dielectric film such that an edge portion thereof is in contact with the first impurity region, to electrically separate the first impurity region from another impurity region, before the step of forming a first impurity region.

In the method of fabricating a semiconductor device in accordance with this invention, the hole portion may be located above a boundary between an edge portion of the element separation dielectric film and the first impurity region.

The first conductivity type may be p-type. This invention makes it possible to reduce the magnitude of current leaking into the semiconductor substrate more effectively when the first conductivity type is p-type, than when it is n-type. It is particularly preferable that the second impurity region is annealed at a temperature between 850°C and 900°C. This will be discussed later. The ions of the first conductivity type are of B, BF₂, etc. The implantation of BF₂ ions is preferably done under conditions such that the BF₂ ions are energized by 10 KeV to 50 KeV, at between 5 x 10¹³ atom/cm² to 1 x 10¹⁵ atom/cm², with the annealing performed for 10 to 60 seconds by lamp-annealing. The energy for the implantation of B ions is 10 KeV to 20 KeV, with all other conditions being the same as for BF₂ ion implantation.

The first impurity region is the source/drain of a field effect transistor, by way of example.

The method of fabricating a semiconductor device in accordance with this invention may further comprise: a step of forming a refractory metal film on the silicide film exposed by the hole portion, before the step of forming a wiring film. The refractory metal film preferably comprises at least one of Ti, TiN, TiW, TaN, and Nb. If a Ti film is used as the refractory metal film, annealing is preferably performed in a nitrogen atmosphere, and a TiN film is preferably formed on the refractory metal film.

In the method of fabricating a semiconductor device in accordance with this invention, annealing may be performed after the refractory metal film is formed. Since this ensures that the surface of a silicide film (such as a TiSi film) does not oxidize, it is possible to reduce the level of the contact resistance.

Note that the refractory metal film may be formed after the annealing. Since this causes oxidation of the surface of the silicide film (such as the TiSi film), it is necessary to remove this oxide layer before the refractory metal film is formed. A method such as reverse sputtering (radio frequency (RF) etching) could be used for this process.

Note that when the word "on" is used to explain the positional relationship between two layers or films of the device in the present application, there may exist other layers or films between those two layers or films.

### Brief Description of the Drawings

Fig. 1 shows a first stage in an embodiment of the method of fabricating a semiconductor device in accordance with this invention;
Fig. 2 shows a second stage in this embodiment of the method of fabricating a semiconductor device in accordance with this invention;
Fig. 3 shows a third stage in this embodiment of the method of fabricating a semiconductor device in accordance with this invention;
Fig. 4 shows a fourth stage in this embodiment of the method of fabricating a semiconductor device in accordance with this invention;
Fig. 5 shows a fifth stage in this embodiment of the method of fabricating a semiconductor device in accordance with this invention;
Fig. 6 is a partial cross-sectional view through a semiconductor device, illustrating the positional relationship of the contact hole;
Figs. 7A and 7B are graphs of the magnitude of junction leakage when the annealing temperature was 730°C and no ion implantation was performed;
Figs. 8A and 8B are graphs of the magnitude of junction leakage when the annealing temperature was 730°C and ion implantation was performed;
Figs. 9A and 9B are graphs of the magnitude of junction leakage when the annealing temperature was 780°C and ion implantation was performed;
Figs. 10A and 10B are graphs of the magnitude of junction leakage when the annealing temperature was 800°C and ion implantation was performed;
Figs. 11A and 11B are graphs of the magnitude of junction leakage when the annealing temperature was 850°C and ion implantation was performed; and
Figs. 12A and 12B are graphs of the magnitude of junction leakage when the annealing temperature was 900°C and ion implantation was performed.

### DESCRIPTION OF PREFERRED EMBODIMENT

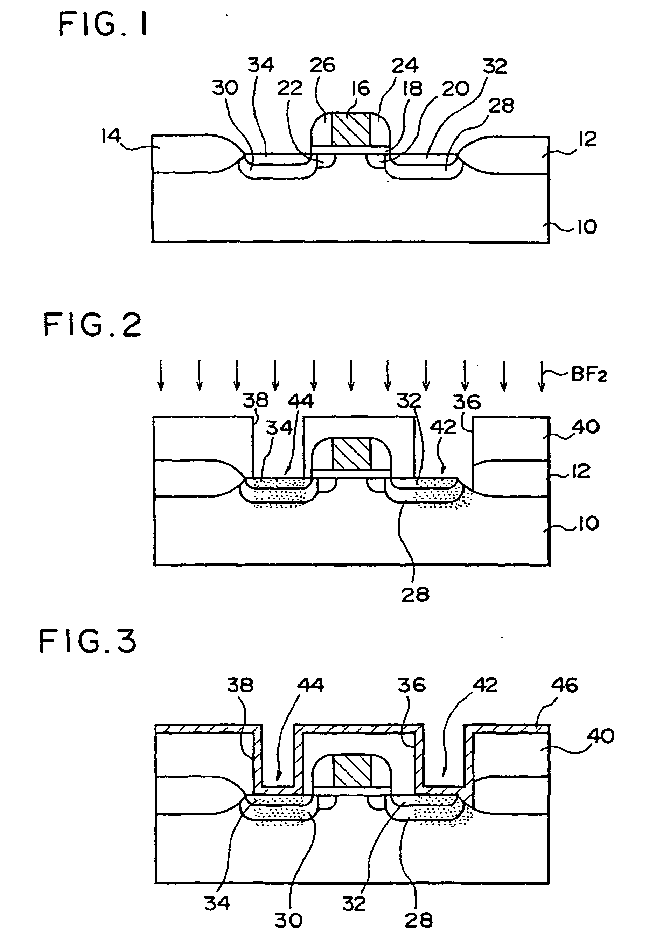

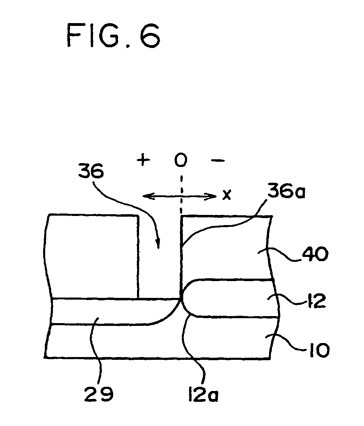

An embodiment of the method of fabricating a semiconductor device in accordance with this invention will now be described, with reference to Figs. 1 to 6. Referring first to Fig. 1, field oxide films 12 and 14, which are typical element separation dielectric films, are formed at a certain distance apart on a main surface of a silicon substrate 10, which is a typical semiconductor substrate. A method such as local oxidation of silicon (LOCOS) could be used as the method of forming the field oxide films 12 and 14, by way of example. A MOS transistor is then formed in the main surface of the silicon substrate 10 between the field oxide film 12 and the field oxide film 14. First of all, a gate oxide film 18 is formed on the main surface of the silicon substrate 10. Thermal oxidation could be used as the method of forming the gate oxide film 18, by way of example.

A gate electrode 16 consisting of a polysilicon film or a stack of alternate layers of polysilicon and silicide films is formed on the gate oxide film 18. Using the gate electrode 16 and the field oxide films 12 and 14 as a mask, ions of BF₂ are implanted into the silicon substrate 10 to form p-type regions 20 and 22 on either side of the gate electrode 16. Side-wall dielectric films 24 and 26 consisting of silicon oxide films are then formed on the side surfaces of the gate electrode 16. The method described below could be used for forming the side-wall dielectric films 24 and 26, by way of example. First, a silicon oxide film is formed by CVD so as to cover the gate electrode 16. This silicon oxide film is then etched by reactive-ion etching. The side-wall dielectric films 24 and 26 could be formed by these steps.

Using the side-wall dielectric films 24 and 26 together with the field oxide films 12 and 14 as a mask, ions of BF₂ are implanted into the silicon substrate 10 to form p-type regions 28 and 30. A film such as a Ti film is then formed by sputtering on the main surface of the silicon substrate 10. Titanium silicide films 32 and 34 are formed on the p-type regions 28 and 30, respectively, by annealing this Ti film in an N₂ or inert gas environment.

Referring now to Fig. 2, a silicon oxide film 40, which is a typical dielectric film, is formed by a method such as CVD over the entire main surface of the silicon substrate 10. Instead of the silicon oxide film, a single-layer film such as a PSG film, SOG film, or BPSG film could be used as this dielectric film, or a multi-layer film comprising any combination of silicon oxide films, PSG films, SOG films, or BPSG films could be used therefor. The silicon oxide film 40 is then selectively etched to form a contact hole 36 through which the titanium silicide film 32 is exposed and a contact hole 38 through which the titanium silicide film 34 is exposed. The contact holes 36 and 38 are merely examples of hole portions. Unavoidable mask alignment error during the formation of the contact hole could cause the contact hole 36 to be located on the boundary between an edge portion of the field oxide film 12 and the p-type region 28. Ions of BF₂ are then implanted into the main surface of the silicon substrate 10 through the contact holes 36 and 38, to form impurity regions 42 and 44.

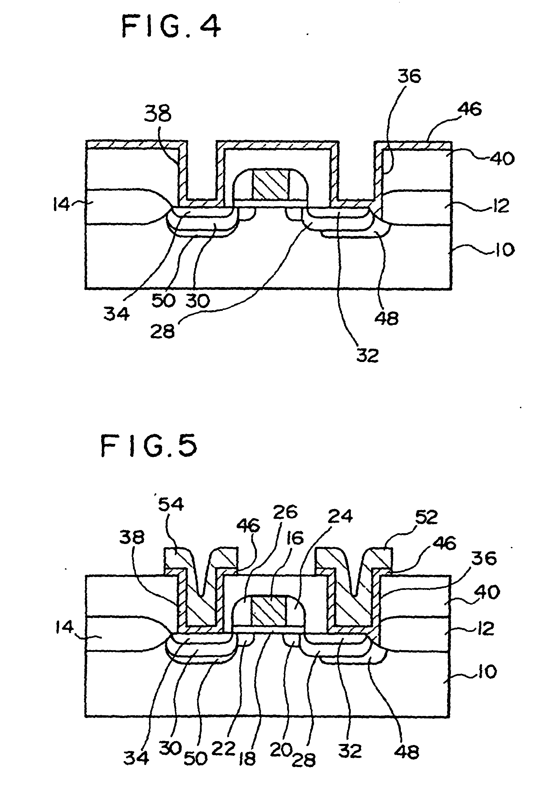

Referring now to Fig. 3, a Ti film 46 is formed over the silicon oxide film 40 and also the contact holes 36 and 38. The impurity regions 42 and 44 are then activated, as shown in Fig. 4, by annealing under conditions of a temperature of 780°C to 900°C. This activation causes the formation of a new p⁺-type region 48 under the p⁺-type region 28 and a new p⁺-type region 50 under the p-type region 30. The environment for this annealing is a nitrogen atmosphere. Thus a TiN film is formed on the Ti film 46.

Referring now to Fig. 5, an aluminum film is formed on the Ti film 46 by using sputtering, by way of example, and this aluminum film is subjected to predetermined patterning. This forms aluminum wiring portions 52 and 54 that are in electrical contact with the source and drain. Note that it is also possible to use wiring of an aluminum alloy which comprises another metal such as copper, instead of this aluminum wiring.

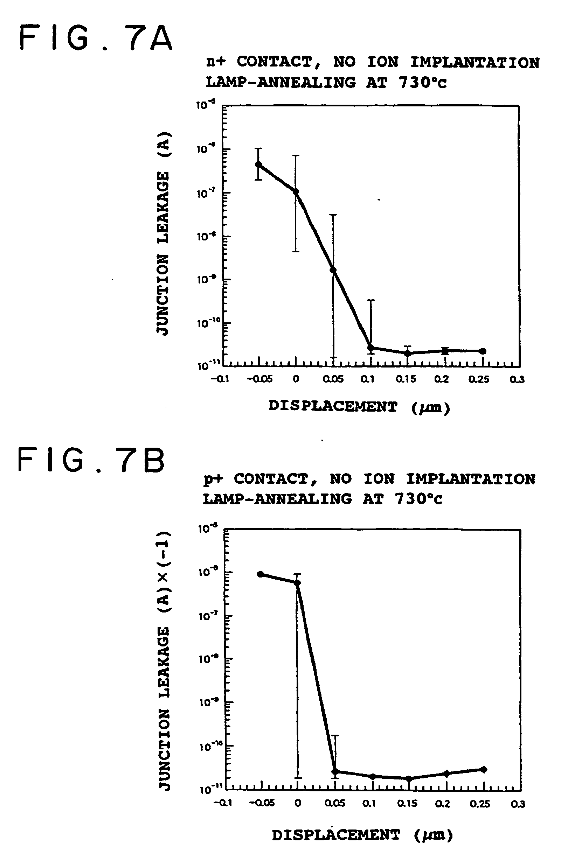

The description now turns to a discussion of the results of experiments that demonstrated how annealing at 780°C to 900°C was effective in lowering the magnitude of currents leaking into the semiconductor substrate. Graphs of these experimental results are shown in Figs. 7A to 12B. The annealing environment was a nitrogen atmosphere. The term "junction leakage" refers to the magnitude of a current that flows through a pn junction between a source/drain and the semiconductor substrate, when a reverse bias voltage is applied thereto. In this case, if the source/drain was n-type, +5 V was applied thereto, and the semiconductor substrate was assumed to be at 0 V. If the source/drain was p-type, -5 V was applied thereto, and the semiconductor substrate was assumed to be at 0 V. The term "displacement" indicates how far an edge surface 36a of the contact hole 36 is located from a reference position, where the location of an edge portion 12a of the field oxide film 12 acts as this reference position, in other words, is zero. A negative value means that the edge surface 36a is located above the field oxide film 12; a positive value means that the contact hole 36 is located completely above an impurity region 29. If the impurity region 29 was n-type, the ion implantation conditions were: P ions, at an energy of 50 KeV, and dosage of 5.00E13/cm². If the impurity region 29 was p-type, the ion implantation conditions were: BF₂ ions, at an energy of 40 KeV, and dosage of 6.30E14/cm². A film consisting of a 8.5 nm thick Ti film and a 100 nm thick TiN film located thereabove was used as the refractory metal film. The Ti and TiN films were formed by reactive sputtering. In the above experimental example, the TiN film was formed by annealing, but in this experimental example, the TiN film was formed by reactive sputtering. A silicide film was thereby formed above the impurity region 29.

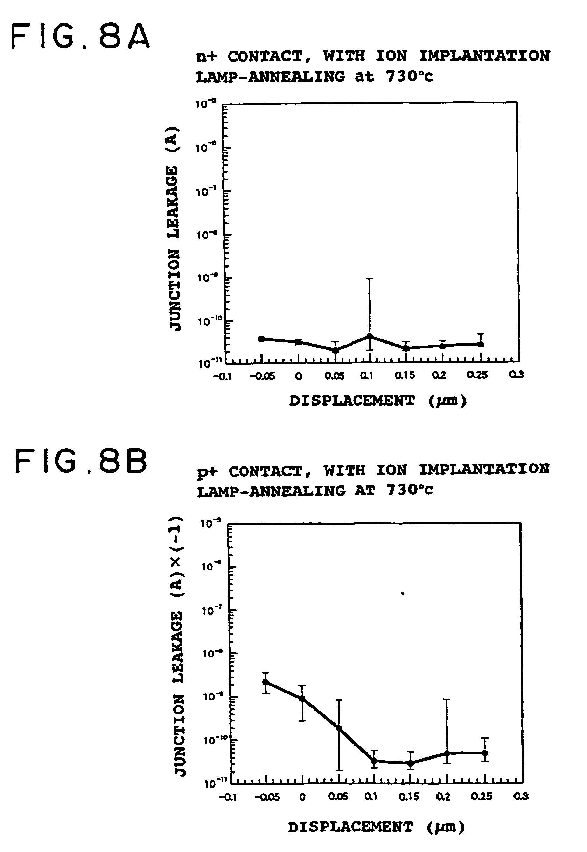

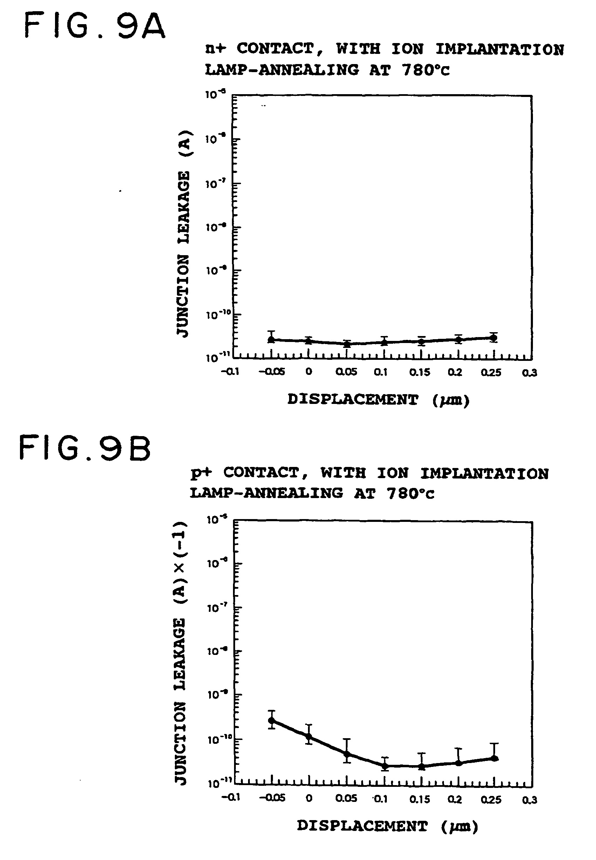

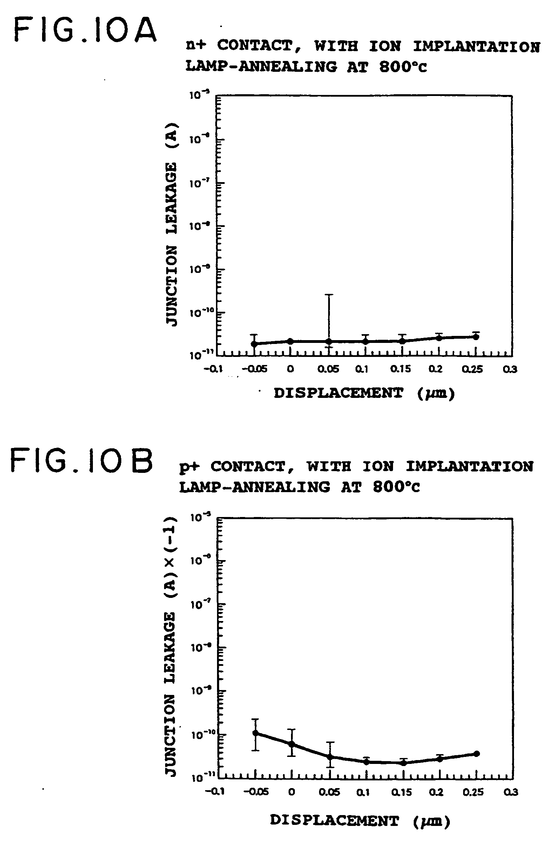

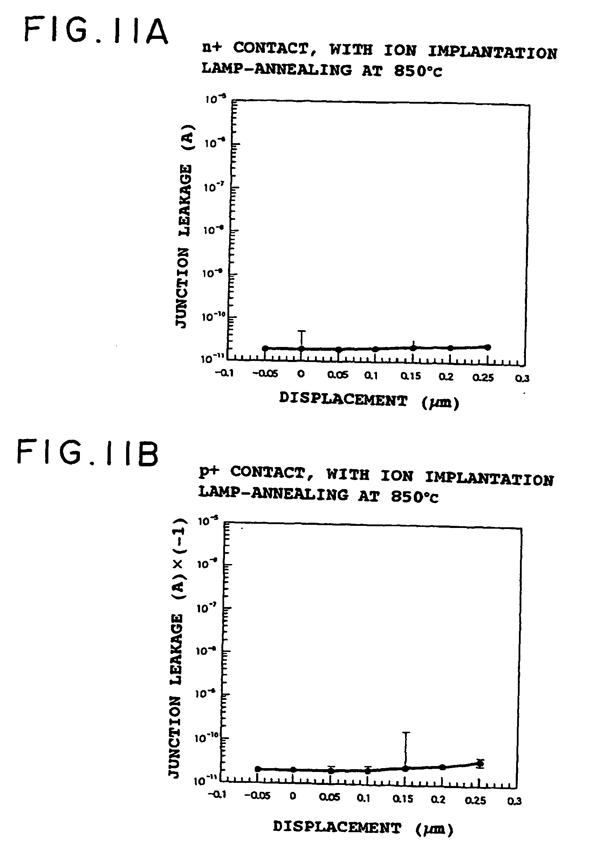

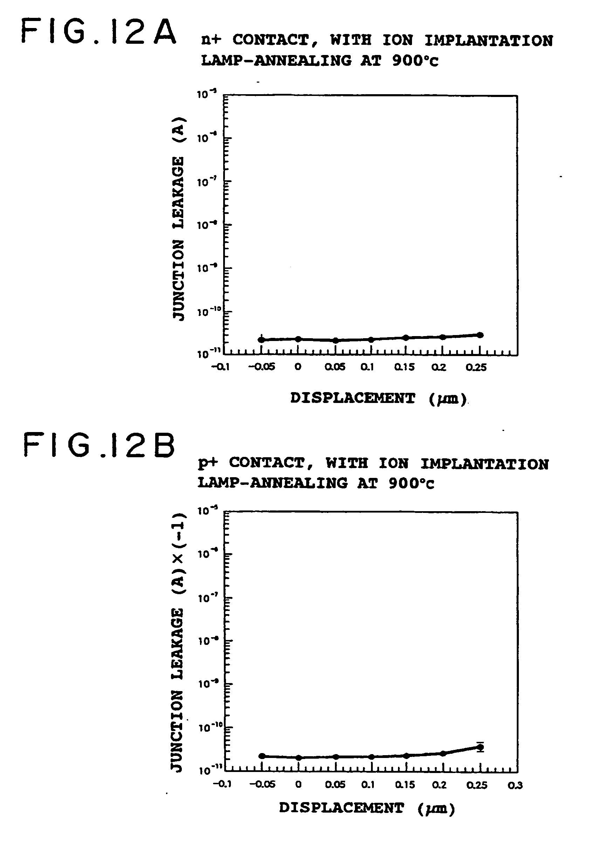

Figs. 7A and 7B are graphs of the results obtained when the annealing temperature was 730°C. Note that no ion implantation was performed in this case. Fig. 7A shows the results obtained when the impurity region 29 was n-type and Fig. 7B shows the results obtained when the impurity region 29 was p-type. Hereinafter, graphs with the suffix A are those of results obtained when the impurity region 29 was n-type and graphs with the suffix B are those of results obtained when the impurity region 29 was p-type. Figs. 8A and 8B are graphs of the results obtained when the annealing temperature was 730°C, Figs. 9A and 9B are graphs of the results obtained when the annealing temperature was 780°C, Figs. 10A and 10B are graphs of the results obtained when the annealing temperature was 800°C, Figs. 11A and 11B are graphs of the results obtained when the annealing temperature was 850°C, and Figs. 12A and 12B are graphs of the results obtained when the annealing temperature was 900°C.

From Figs 7A to 12B, it can be seen that if the displacement is positive, the contact hole 36 is located completely above the impurity region 29, so that in this case the magnitude of junction leakage is low. If the displacement is negative, however, differences in junction leakage will occur. It is clear from these graphs that the magnitude of leakage current is reduced more when annealing is at a temperature higher than 730°C, than when annealing is at a temperature of 730°C. The magnitude of leakage current can be reduced further when the impurity region is p-type, than when it is n-type. In particular, this effect is greater when the impurity region is p-type and annealing is at 850°C to 900°C.

## Claims

1. A method of fabricating a semiconductor device, comprising the steps of:
a) forming a first impurity region (28, 30) of a first conductivity type on a main surface of a semiconductor substrate (10);
b) forming a silicide film (32, 34) on said first impurity region (28, 30);
c) forming a dielectric film (40) on said main surface, such that said dielectric film (40) has a hole portion (36, 38) through which is exposed said silicide film (32, 34);
d) implanting ions of said first conductivity type through said hole portion (36, 38) into said main surface, to form a second impurity region (42, 44) of said first conductivity type, overlapping at least part of said first impurity region (28, 30);
e) annealing said second impurity region (42, 44), to activate said second impurity region (42, 44); and
f) forming a wiring film (52, 54) on said dielectric film (40) and within said hole portion (36, 38), to provide electrical contact with said silicide film (32, 34);
**characterized in that** step e) is performed at 780° to 900°C

2. The method of claim 1, wherein step a) is preceded by
g) forming an element separation dielectric film (12,14), and
step a) is performed such that said first impurity region (28, 30) is in contact with an edge portion of said element separation dielectric film (12, 14), to electrically separate said first impurity region (28, 30) from another impurity region.

3. The method of claim 2, wherein said hole portion (36, 38) is located above a boundary between the edge portion of said element separation dielectric film (12, 14) and said first impurity region (28, 30).

4. The method of any one of claims 1 to 3, wherein step f) is preceded by
g) forming a refractory metal film on said silicide film (32, 34) exposed by said hole portion (36, 38).

5. The method of claim 4, wherein said refractory metal film comprises at least one of Ti, TiN, TiW, TaN, and Nb.

6. The method of claim 4 or 5, wherein step e) is performed in a nitrogen atmosphere.

7. The method of any one of claims 4 to 6, wherein step e) is performed after step g).

8. The method of any one of claims 4 to 6, wherein step e) is performed before step g).

9. The method of any one of claims 1 to 8, wherein said first impurity region (28, 30) comprises a source/drain.

10. The method of any one of claims 1 to 9, wherein said first conductivity type is p-type.

11. The method of claim 10, wherein said ions of said first conductivity type comprise at least one of B and BF₂.

12. The method of any one of claims 1 to 11,wherein said annealing temperature is 850°C to 900°C.

## Patentansprüche

1. Verfahren der Herstellung eines Halbleiterbauelements, umfassend die Schritte:
a) Bilden einer ersten Dotierstoffzone (28, 30) eines ersten Leitungstyps auf einer Hauptfläche eines Halbleitersubstrats (10);
b) Bilden eines Silizidfilms (32, 34) auf der ersten Dotierstoffzone (28, 30);
c) Bilden eines dielektrischen Films (40) auf der Hauptfläche derart, daß der dielektrische Film (40) einen Lochabschnitt (36, 38) aufweist, durch den der Silizidfilm (32, 34) freiliegt;
d) Implantieren von Ionen des ersten Leitungstyps durch den Lochabschnitt (36, 38) in die Hauptfläche zur Bildung einer zweiten Dotierstoffzone (42, 44) des ersten Leitungstyps, die wenigstens einen Teil der ersten Dotierstoffzone (28, 30) überlappt;
e) Wärmebehandeln der zweiten Dotierstoffzone (42, 44) zur Aktivierung der zweiten Dotierstoffzone (42, 44); und
f) Bilden eines Verdrahtungsfilms (52, 54) auf dem dielektrischen Film (40) und innerhalb des Lochabschnitts (36, 38) zur Schaffung eines elektrischen Kontakts mit dem Silizidfilm (32, 34);
**dadurch gekennzeichnet, daß** Schritt e) bei 780 ° bis 900° C ausgeführt wird.

2. Verfahren nach Anspruch 1, bei dem Schritt a) vorangeht
g) Bilden eines dielektrischen Elementtrennfilms (12, 14), und
bei dem Schritt a) derart ausgeführt wird, daß die erste Dotierstoffzone (28, 30) mit einem Kantenabschnitt des dielektrischen Elementtrennfilms (12, 14) im Kontakt steht, um die erste Dotierstoffzone (28, 30) von einer anderen Dotierstoffzone zu trennen.

3. Verfahren nach Anspruch 2, bei dem der Lochabschnitt (36, 38) über einer Grenze zwischen dem Kantenabschnitt des dielektrischen Elementtrennfilms (12, 14) und der ersten Dotierstoffzone (28, 30) gelegen ist.

4. Verfahren nach einem der Ansprüche 1 bis 3, bei dem Schritt f) vorangeht
g) Ausbilden eines feuerfesten Metallfilms auf dem Silizidfilm (32, 34), der durch den Lochabschnitt (36, 38) freiliegt.

5. Verfahren nach Anspruch 4, bei dem der feuerfeste Metallfilm wenigstens eines von Ti, TiN, TiW, TaN und Nb umfaßt.

6. Verfahren nach Anspruch 4 oder 5, bei dem Schritt e) in einer Stickstoffatmosphäre ausgeführt wird.

7. Verfahren nach einem der Ansprüche 4 bis 6, bei dem Schritt e) nach Schritt g) ausgeführt wird.

8. Verfahren nach einem der Ansprüche 4 bis 6, bei dem Schritt e) vor Schritt g) ausgeführt wird.

9. Verfahren nach einem der Ansprüche 1 bis 8, bei dem die erste Dotierstoffzone (28, 30) eine Source/Drain umfaßt.

10. Verfahren nach einem der Ansprüche 1 bis 9, bei dem der erste Leitungstyp der p-Typ ist.

11. Verfahren nach Anspruch 10, bei dem die lonen des ersten Leitungstyps wenigsten eines von B und BF₂ umfassen.

12. Verfahren nach einem der Ansprüche 1 bis 11, bei dem die Wärmebehandlungstemperatur 850 °C bis 900° C beträgt.

## Revendications

1. Procédé de fabrication d'un dispositif à semiconducteurs comprenant les stades dans lesquels :
a) on forme une première région (28, 30) d'impureté d'un premier type de conductivité sur une surface principale d'un substrat (10) semiconducteur ;
b) on forme un film (32, 34) de siliciure sur la première région (28, 30) d'impureté ;
c) on forme un film (40) diélectrique sur la surface principale de façon à ce que le film (40) diélectrique ait une partie (36, 38) de trou par laquelle le film (32, 34) de siliciure est mis à nu ;
d) on implante des ions du premier type de conductivité en passant par la partie (36, 38) de trou dans la surface principale pour former une deuxième région (42, 44) d'impureté du premier type de conductivité chevauchant au moins une partie de la première région (28, 30) d'impureté ;
e) on recuit la deuxième région (42, 44) d'impureté pour activer la deuxième région (42, 44) d'impureté ; et
f) on forme un film (52, 54) de câblage sur le film (40) diélectrique et dans la partie (36, 38) de trou pour ménager un contact électrique avec le film (32, 34) de siliciure ;
**caractérisé en ce que** l'on effectue le stade e) entre 780 et 900° C.

2. Procédé suivant la revendication 1, dans lequel le stade a) est précédé de
g) la formation d'un film (12, 14) diélectrique de séparation des éléments, et
on effectue le stade a) de façon à ce que la première région (28, 30) d'impureté soit en contact avec une partie de bord du film (12, 14) diélectrique de séparation des éléments pour séparer électriquement la première région (28, 30) d'impureté d'une autre région d'impureté.

3. Procédé suivant la revendication 2, dans lequel la partie (36, 38) de trou est disposée au-dessus d'une limite entre la partie de bord du film (12, 14) diélectrique de séparation des éléments et la première région (28, 30) d'impureté.

4. Procédé suivant l'une quelconque des revendications 1 à 3, dans lequel le stade (f) est précédé de
g) la formation d'un film métallique réfractaire sur le film (32, 34) de siliciure mis à nu par la partie (36, 38) de trou.

5. Procédé suivant la revendication 4, dans lequel le film métallique réfractaire comprend au moins l'un de Ti, TiN, TiW, TaN et Nb.

6. Procédé suivant la revendication 4 ou 5, dans lequel on effectue le stade e) dans une atmosphère d'azote.

7. Procédé suivant l'une quelconque des revendications 4 à 6, dans lequel on effectue le stade e) après le stade g).

8. Procédé suivant l'une quelconque des revendications 4 à 6, dans lequel on effectue le stade e) avant le stade g).

9. Procédé suivant l'une quelconque des revendications 1 à 8, dans lequel la première région (28, 30) d'impureté comprend un source/drain.

10. Procédé suivant l'une quelconque des revendications 1 à 9, dans lequel le premier type de conductivité est un type p.

11. Procédé suivant la revendication 10, dans lequel les ions du premier type de conductivité comprennent au moins l'un de B et de BF₂.

12. Procédé suivant l'une quelconque des revendications 1 à 11, dans lequel la température de recuit est comprise entre 850°C et 900°C.
